(19)

**Europäisches Patentamt**
**European Patent Office**
**Office européen des brevets**

(11) **EP 2 337 144 B1**

(12) **EUROPEAN PATENT SPECIFICATION**

(45) Date of publication and mention
of the grant of the patent:
**18.03.2020 Bulletin 2020/12**

(51) Int Cl.:
*H01M 14/00* *(2006.01)*     *H01L 31/04* *(2014.01)*
*H01G 9/20* *(2006.01)*

(21) Application number: **09819265.1**

(86) International application number:
**PCT/JP2009/067608**

(22) Date of filing: **09.10.2009**

(87) International publication number:
**WO 2010/041732 (15.04.2010 Gazette 2010/15)**

(54) **DYE-SENSITIZED SOLAR CELLS**

FARBSTOFFSENSIBILISIERTE SOLARZELLEN

CELLULES SOLAIRES SENSIBILISÉES À UN COLORANT

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **10.10.2008 JP 2008263457
05.10.2009 JP 2009231125**

(43) Date of publication of application:
**22.06.2011 Bulletin 2011/25**

(73) Proprietor: **NIPPON STEEL NISSHIN CO., LTD.
Chiyoda-ku
Tokyo 100-8366 (JP)**

(72) Inventors:
- **NISHIDA Yoshikatu
  Sakai-shi
  Osaka 592-8332 (JP)**
- **FUJII Takahiro
  Sakai-shi
  Osaka 592-8332 (JP)**
- **IZUMI Keiji
  Sakai-shi
  Osaka 592-8332 (JP)**
- **ARAKAWA Hironori
  Tsukuba-shi
  Ibaraki 305-0032 (JP)**
- **YAMAGUCHI Takeshi
  Tokyo 130-0012 (JP)**

(74) Representative: **Wagner, Karl H. et al
Wagner & Geyer Partnerschaft mbB
Patent- und Rechtsanwälte
Gewürzmühlstrasse 5
80538 München (DE)**

(56) References cited:
**JP-A- 2002 298 936     JP-A- 2005 285 472
JP-A- 2006 147 261     JP-A- 2006 318 770
JP-A- 2008 034 110     JP-A- 2008 034 110
JP-A- 2009 026 532**

- **MA T ET AL: "Properties of several types of novel
  counter electrodes for dye-sensitized solar
  cells", JOURNAL OF ELECTROANALYTICAL
  CHEMISTRY AND INTERFACIALELECTRO
  CHEMISTRY, ELSEVIER, AMSTERDAM, NL, vol.
  574, no. 1, 15 December 2004 (2004-12-15), pages
  77-83, XP004633924, ISSN: 0022-0728, DOI:
  10.1016/J.JELECHEM.2004.08.002**
- **Minna Toivola ET AL: "Industrial sheet metals for
  nanocrystalline dye-sensitized solar cell
  structures", SOLAR ENERGY MATERIALS AND
  SOLAR CELLS., vol. 90, no. 17, 10 July 2006
  (2006-07-10) , pages 2881-2893, XP055561482, NL
  ISSN: 0927-0248, DOI:
  10.1016/j.solmat.2006.05.002**
- **Kati Miettunen ET AL: "Initial Performance of Dye
  Solar Cells on Stainless Steel Substrates",
  JOURNAL OF PHYSICAL CHEMISTRY C, vol. 112,
  no. 10, 19 February 2008 (2008-02-19), pages
  4011-4017, XP055561496, ISSN: 1932-7447, DOI:
  10.1021/jp7112957**

**Description**

Technical Field

The present invention relates to a dye-sensitized solar cell using a stainless steel as a constituent material of a counter electrode (positive electrode) disposed facing a photoelectrode.

Background Art

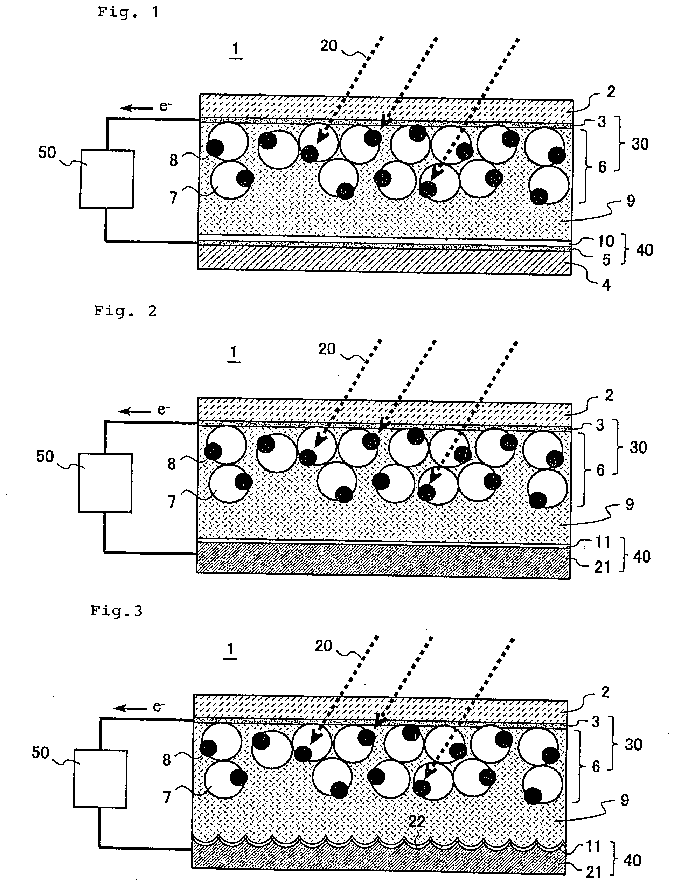

Solar cell in which silicon is mainly used as a photoelectric conversion element has conventionally been used. Practical application of a "dye-sensitized solar cell" is being studied as a more economic next generation solar cell.
Constitution of a general dye-sensitized solar cell is schematically shown in Fig. 1. A light-transmitting and conductive material 3 is provided on the surface of a light-transmitting substrate 2, and a semiconductor layer 6 constituted of a semiconductor particle 7 having a sensitizing dye 8 supported thereon is formed on the surface of the light-transmitting and conductive material 3. In Fig. 1, a size of the semiconductor particle 7 having a sensitizing dye 8 supported thereon is extremely overdrawn (the same is applied to Figs. 2 and 3 described hereinafter). A photoelectrode 30 is constituted of the light-transmitting and conductive material 3 and the semiconductor layer 6. A counter electrode 40 is disposed so as to face the photoelectrode 30, and a solar cell 1 is constituted of the photoelectrode 30, the counter electrode 40 and an electrolyte 9 interposed between those electrodes. The counter electrode 40 is constituted of a conductive material 5 and a catalyst layer 10 provided on the surface thereof.
The light-transmitting and conductive material 3 is constituted of a transparent conductive film such as ITO (indium-tin oxide), FTO (fluorine-doped tin oxide), TO (tin oxide) or ZnO (zinc oxide), and a glass, a plastic film and the like are used as the light-transmitting substrate 2. On the other hand, light transmittance is not required at the counter electrode 40 side. However, from the standpoint of corrosion resistance and the like, there is a concern to employ a general metal material other than noble metal as the conductive material 5, and there are many cases that the same conductive material as the photoelectrode is provided on a substrate 4 such as a glass. In fact, stainless steel such as SUS430 or SUS304 vigorously corrodes in an electrolyte, and as a result, cannot be used as the conductive material 5.
The semiconductor layer 6 constituting the photoelectrode 30 is a porous layer using semiconductor particles having a large specific surface area, such as $TiO_2$, and a sensitizing dye 8 such as ruthenium complex is supported on the surface of the semiconductor particle 7. Electrolyte containing iodine ($I_2$) and an iodide ion is generally used as the electrolyte. When incident light 20 reaches the sensitizing dye 8, the sensitizing dye 8 (for example, ruthenium complex) absorbs light and is excited, and its electron is incorporated in the semiconductor particle 7 (for example, $TiO_2$). The sensitizing dye 8 in an oxidized state by having freed the exited electron receives an electron from an ion (for example, iodide ion $I^-$) of the electrolyte 9, and returns to a base state. In this case, the ion (for example, $I^-$) in the liquid is oxidized to convert into an ion having different valency (for example, $I_3^-$), diffuses in the counter electrode 40, receives an electron from the counter electrode 40, and returns to the original ion (for example, $I^-$). By this action, the electron moves with the route of sensitizing dye 8 → semiconductor particle 7 → light-transmitting and conductive material 3 → load 50 → conductive material 5 → catalyst layer 10 → electrolyte 9 → sensitizing dye 8. As a result, electric current activating the load 50 is generated.
Patent Documents 1 to 7 describe using a conductive film comprising a corrosion-resistant metal such as platinum in a counter electrode of a dye-sensitized solar cell. Furthermore, there is the example that the counter electrode is constituted of a platinum plate having a thickness of 1 mm (Patent Document 6) .
Patent Document 1: JP-A-11-273753 (1999)
Patent Document 2: JP-A-2004-311197
Patent Document 3: JP-A-2006-147261
Patent Document 4: JP-A-2007-48659
Patent Document 5: JP-A-2004-165015
Patent Document 6: JP-A-2005-235644
Patent Document 7: JP-A-2007-200656

Disclosure of the Invention

Problems that the Invention is to Solve

Conversion efficiency of the current dye-sensitized solar cell is low as compared with a silicon solar cell, and it is one of large problems to increase the efficiency. As the technique aiming at high efficiency of the dye-sensitized solar cell, for example, Patent Document 1 discloses the technique that a plurality of electrode couples are laminated, and a counter electrode most away from an incident side of light is formed of a reflective electrode layer, thereby improving conversion efficiency and additionally increasing electric power supply per unit area. Specifically, high efficiency is achieved by absorbing incident light in a plurality of electrode layers and further absorbing light reflected at a reflective counter electrode in a reverse route.

However, the technique of Patent Document 1 has the disadvantage that because expensive metals such as platinum, gold, silver and titanium or their alloys, having excellent corrosion resistance to an electrolyte solution are used as the reflective electrode layer, material cost is very increased. In particular, platinum has high conductivity and shows catalytic action, and is therefore very effective as a counter electrode material. However, platinum is very expensive, and it is therefore strongly desired to reduce its use amount to a requisite minimum amount.

Patent Document 3 discloses a method of forming a corrosion-resistant metal material film such as titanium or tantalum, having a convex-concave structure having a scale of from 1 to 1,000 nm on the surface of a resin-made counter electrode substrate by a sputtering method, and forming a platinum film on the surface thereof. According to this method, contact area between the counter electrode and the electrolyte solution is increased. As a result, surface resistance is reduced, and sufficient conversion efficiency is obtained even though a thickness of the platinum film is decreased. However, because this method forms the corrosion-resistant metal material film by a sputtering method, increase in preparation cost of the counter electrode is unavoidable, and a structure achieving lower cost is demanded.

Thus, the current situation is that a considerable amount of a noble metal such as platinum is used in an electrode of a dye-sensitized solar cell, and involves increase in cost due to the use of an expensive noble metal.

Patent Document 7 contains the description that an alloy such as stainless steel may be used as a material of a counter electrode. However, the example of actually using stainless steel is not shown. General-purpose stainless steel does not have sufficient corrosion resistance to an electrolyte, and the example of realizing excellent photoelectric conversion efficiency and durability by using stainless steel in an electrode is not yet known.

JP 2008 034 110 A discloses an electrode material for dye-sensitized solar cell comprising a ferritic, an austenitic or a dual-phase stainless steel. These stainless steels use their own surface as a catalyst for the electrode reaction and are inferior in photoelectric conversion efficiency.

MA T ET AL: "Properties of several types of novel counter electrodes for dye-sensitized solar cells", J. Electroanal. Chem. and Interfac. Electrochem., 2004, 574, 77-83 discloses counter electrodes for the dye-sensitized solar cell one of which is SUS304 stainless steel covered with 50 nm of Pt catalyst layer. SUS304 stainless steel has poor corrosion resistance against the electrolytic solution of the dye-sensitized solar cell, and the thickness of the Pt catalyst layer is rather thick.

JP 2005 285 472 A discloses a technique for roughening the metal surface of a photoelectrode of a dye-sensitized solar cell in order to improve the adhesion between the semiconductor particles and photoelectrode surface.

Sol. Ener. Mater. Solar Cells, 2006, 90, 2881-2893, discloses dye sensitized solar cells comprising industrial steel sheet metals as the counter electrode.

J. Phys. Chem. C, 2008, 112, 4011-4017, also discusses the suitability of stainless steel as a counter electrode support in dye sensitized solar cells.

In view of the above current situation, the present invention has an object to provide a dye-sensitized solar cell having excellent photoelectric conversion efficiency and capable of saving the amount of a catalyst used, by using, for a counter electrode, an inexpensive metal material showing excellent corrosion resistance in an electrolyte of a dye-sensitized solar cell.

Means for Solving the Problems

The above object is achieved by a dye-sensitized solar cell as set forth in claim 1. Further embodiments of the invention are claimed in the dependent claims. The celle inter alia comprises a photoelectrode comprising a light-transmitting and conductive material and a semiconductor layer having a sensitizing dye supported thereon, formed on the surface of the light-transmitting and conductive material, an electrolyte and a counter electrode, wherein the counter electrode is constituted of a material comprising a substrate comprising a ferrite stainless steel that may have property that corrosion loss is 1 g/m$^2$ or less when dipped in the electrolyte heated to 80°C for 500 hours, and a catalyst thin film layer formed on the surface of the substrate, and the semiconductor layer of the photoelectrode and the catalyst thin film layer of the counter electrode face through the electrolyte.

The ferrite stainless steel has a composition of, in % by mass, C: 0.15% or less, Si: 1.2% or less, Mn: 1.2% or less, P: 0.04% or less, S: 0.03% or less, Ni: 0.6% or less, Cr: 16 to 32%, preferably 17 to 32%, Mo: 0.3 to 3%, preferably 0.8 to 3%, Cu: 0 to 1%, Nb: 0 to 1%, Ti: 0 to 1%, Al: 0 to 0.2%, N: 0.025% or less, B: 0 to 0.01%, and the remainder being Fe and unavoidable impurities, is preferred. In the case of utilizing standard steel grade, for example, stainless steel which is ferrite steel grade defined in JIS G4305 and containing Cr: 16 to 32% by mass, preferably 17 to 32% by mass and Mo: 0.3 to 3% by mass, preferably 0.8 to 3% by mass, can be employed.

As the counter electrode, it is more effective for the improvement of photoelectric conversion efficiency to use an electrode comprising a stainless steel plate having pit-shaped concave portions with an average opening size D of 5 $\mu$m or less, for example, from 0.3 to 5 $\mu$m, in a proportion of an area ratio of 10% or more on the surface thereof and a catalyst thin film layer formed on the surface of the stainless steel plate. The surface having the pit-shaped concave portions is that surface roughness SRa is, for example, 0.1 to 1.5 $\mu$m. The term "in a proportion of an area ratio of 10% or more" used herein means that the proportion of a projected area of a region having the pit-shaped concave portions formed thereon (that is, a region excluding pit-ungenerated portion) to the projected area of the observation region when seeing the surface of a steel plate in a parallel direction to a plate thickness direction is 10% or more. The surface roughness SRa means an average roughness in a center plane (standard plane) when a surface roughness curve is approximated with a sine curve, and is a value obtained by measuring height of each point using, for example, a stylus three-dimensional surface roughness gauge or a laser microscope and analyzing those measurement values in terms of three-dimensional surface roughness. The measurement region is, for example, a rectangular region having one side of 40 $\mu$m or more (for example, 50 $\mu$m $\times$ 50 $\mu$m).

Advantage of the Invention

The dye-sensitized solar cell of the present invention uses a stainless steel plate in a substrate of a counter electrode, and therefore has excellent strength and corrosion resistance. Additionally, because high photoelectric conversion efficiency can be realized even though the amount of an expensive catalyst substance is an extremely slight amount, merit on cost is large. Therefore, the present invention can contribute to the spread of a dye-sensitized solar cell.

Best Mode for Carrying out the Invention

The constitution of the dye-sensitized solar cell of the present invention is schematically shown in Fig. 2. A photoelectrode 30 and an electrolyte 9 can basically have the same constitution as the conventional constitution. On the other hand, a counter electrode 40 is constituted of a material comprising a stainless steel substrate 21 as a substrate and a catalyst thin film layer 11 formed on the surface thereof. The mechanism that electromotive force of a cell is generated is the same as in the conventional dye-sensitized solar cell. An electron moves with the route of sensitizing dye 8 $\rightarrow$ semiconductor particle 7 $\rightarrow$ light-transmitting and conductive material 3 $\rightarrow$ load 50 $\rightarrow$ stainless steel substrate 21 $\rightarrow$ catalyst thin film layer 11 $\rightarrow$ electrolyte 9 $\rightarrow$ sensitizing dye 8.

The constitution of a cell using a stainless steel substrate having a roughened surface 22 as a stainless steel substrate 21 constituting the counter electrode 40 in the dye-sensitized solar cell of the present invention is schematically shown in Fig. 3. The catalyst thin film layer is formed on the roughened surface 22.

The elements specifying the present invention are described below.

Stainless Steel Grade of Counter Electrode

As an electrolyte of a dye-sensitized solar cell, an organic solvent containing iodine ($I_2$) and an iodide ion is generally used. An electrode material must be constituted of a material stably exhibiting excellent corrosion resistance in the electrolyte over a long period of time. The counter electrode utilizes a platinum catalyst substance. It is indispensable for the practical application of a cell that the metal material itself of the substrate exhibits sufficient corrosion resistance in the electrolyte even in a bare state (the state that the substrate is not covered with platinum or the like). As a result of investigations by the present inventors, it has been found that when the substrate of the counter electrode is constituted of stainless steel, it is very effective to apply stainless steel having the property that corrosion loss when dipped in the electrolyte heated to 80°C for 500 hours is 1 g/m$^2$ or less. The surface of the counter electrode is covered with a catalyst layer such as platinum. Therefore, the stainless steel that the corrosion loss in the above severe test environment in the so-called bare state (the state that a covering layer is not formed) is 1 g/m$^2$ or less generally has sufficient durability on the production of a popularized dye-sensitized solar cell to be mounted on an instrument for personal use. Furthermore, the stainless steel having the property that the corrosion loss - when dipped in the electrolyte for 1,000 hours is 1 g/m$^2$ or less is further advantageous particularly on the production of a dye-sensitized solar cell having high reliability.

As a result of detailed investigations, the present inventors have found that when a certain amount or more of Cr and Mo is contained in stainless steel, the stainless steel can have excellent corrosion resistance that dissolution in an electrolyte solution containing iodine ($I_2$) and an iodide ion and using an organic solvent does not substantially proceed.

It is generally considered that stainless steel has a weak point in corrosion resistance to an aqueous solution containing chloride ion Cl$^-$, and to improve the corrosion resistance, an increased amount of Cr and addition of Mo are effective. For example, in ferrite SUS444 suitable for a water heater, 17% by mass or more of Cr and 1.75% by mass or more of Mo are securely contained, and even in SUS316 which is high corrosion-resistant austenite general-purpose steel grade, 16% by mass or more of Cr and 2% by mass or more of Mo are securely contained. However, corrosion resistance of stainless steel to iodide ion which is the same halogen ion is not sufficiently known. Furthermore, iodine corrodes a metal such as zinc or copper by its strong oxidation power, but corrosion behavior to stainless steel is not sufficiently known. The reason for this is that the environment exposed to iodine and iodide ion is almost non-existent in natural world and regular life. In particular, regarding an electrolyte containing iodine ($I_2$) and iodide ion when a solvent is not water but is an organic material, the relationship between the composition of stainless steel and corrosion resistance is not almost recognized. It is known that SUS304 which is general-purpose steel grade is vigorously corroded in the electrolyte, and application of a stainless steel material to a dye-sensitized solar cell is avoided. This fact was the factor damping motivation of attempting detailed investigations.

As a result of detailed investigations, the present inventors have found that when Cr content is 16% by mass or more and Mo content is 0.3% by mass or more in a stainless steel material, the stainless steel material exhibits excellent corrosion resistance that dissolution does not almost occur in an electrolyte containing iodine ($I_2$) and iodide ion, applied to a dye-sensitized solar cell. Furthermore, when Cr content is 17% by mass or more and Mo content is 0.8% by mass or more, a dye-sensitized solar cell having higher reliability can be produced. Even in the case that the use is daily hot aqueous environment as described above, it is necessary to take the action, for example, that Mo is added in a relatively large amount of 1.75% by mass or more in order to impart corrosion resistance sufficiently durable against the environment to stainless steel. It was clarified that as compared with this, corrosion resistance to an electrolyte solution of a dye-sensitized solar cell in which iodine ($I_2$) and iodide ion are present in an organic solvent is remarkably improved from a range of smaller addition amount of Mo. Furthermore, this tendency does not receive so much the influence of steel grade of austenite type or ferrite type, the influence by other elements added is small. It is considered that this point does not directly follow the corrosion resistance improvement mechanism of stainless steel to chloride ion in an aqueous solvent.

In the present invention, stainless steel having the following composition range can be applied to ferrite steel grade and austenite steel grade, respectively. Unless otherwise indicated, "%" regarding the content of alloy element means "% by mass".

Ferrite Steel Grade

Ferrite stainless steel having a composition of C: 0.15% or less, Si: 1.2% or less, Mn: 1.2% or less, P: 0.04% or less, S: 0.03% or less, Ni: 0.6% or less, Cr: 16 to 32%, preferably 17 to 32%, Mo: 0.3 to 3%, preferably 0.8 to 3%, Cu: 0 to 1%, Nb: 0 to 1%, Ti: 0 to 1%, Al: 0 to 0.2%, N: 0.025% or less, B: 0 to 0.01%, and the remainder being Fe and unavoidable impurities is suitable.

In the case of utilizing standard steel grade, for example, stainless steel which is ferrite steel grade defined in JIS G4305 and containing Cr: 16 to 32% by mass, preferably 17 to 32% by mass, and Mo: 0.3 to 3% by mass, preferably 0.8 to 3% by mass, is applied.

Austenite Steel Grade

Austenite stainless steel having a composition of C: 0.15% or less, Si: 4% or less, Mn: 2.5% or less, P: 0.045% or less, S: 0.03% or less, Ni: 6 to 28%, Cr: 16 to 32%, preferably 17 to 32%, Mo: 0.3 to 7%, preferably 0.8 to 7%, Cu: 0 to 3.5%, Nb: 0 to 1%, Ti: 0 to 1%, Al: 0 to 0.1%, N: 0.3% or less, B: 0 to 0.01%, and the remainder being Fe and unavoidable impurities is suitable.

In the case of utilizing standard steel grade, for example, stainless steel which is austenite steel grade defined in JIS G4305 and containing Cr: 16 to 32% by mass, preferably 17 to 32% by mass, and Mo: 0.3 to 7% by mass, preferably 0.8 to 7% by mass, is applied.

Where the Cr content is less than 16% or the Mo content is less than 0.3%, it is difficult to stably obtain excellent corrosion resistance such that the dissolution of the material does not almost occur in the electrolyte solution containing iodine ($I_2$) and iodide, applied to a dye-sensitized solar cell. To further improve reliability, in the case of ferrite type it is preferred to contain Cr in an amount of 17% or more and Mo in an amount of 0.8% or more, and it is further preferred to contain Cr in an amount of 18% or more and Mo in an amount of 1% or more. In the case of austenite type it is preferred to contain Cr in an amount of 17% or more and Mo in an amount of 0.8% or more, and it is further preferred to contain Cr in an amount of 18% or more and Mo in an amount of 2% or more. However, where the contents of Cr and Mo are excessive, the negative effect of, for example, impairing production ability becomes remarkable. For this reason, the Cr content is desirably 32% or less, and further preferably 30% or less. On the other hand, the Mo content is desirably 3% or less in the case of the ferrite type, and is desirably 7% or less in the case of the austenite type. The lower limit "0" of the element content means that the content of the element is the measurement limit or lower in an analytical method in a general iron-making site.

As elements other than above, elements such as V: 0.3% or less, Zr: 0.3% or less, and Ca, Mg, Co and REM (rare earth element) with the total amount of 0.1% or less, are allowed to be contained. There is a case that those elements are unavoidably contained from raw materials such as scrap. However, the effect of the present invention is not impaired so long as those are contained in the above ranges.

Regarding stainless steels having various compositions, the result of examining corrosion resistance to a test liquid containing iodine ($I_2$) and iodide ion, simulating an electrolyte of a dye-sensitized solar cell are shown below.

Various stainless steels having compositions shown in Table 1 were melted, cold-rolled annealed steel plates (2D finishing materials) having a plate thickness of from 0.28 to 0.81 mm were produced by a general stainless steel production step, and those were used as materials under test. In Table 1, the column of structure is that "α" means a ferrite type and "γ" means an austenite type. The hyphen "-" in the Table means that the content is the measurement limit or lower in a general analytical method at a steel-making site.

TABLE 1

| Classification | Steel No. | Chemical composition (% by mass) | | | | | | | | | | | | | | Structure |
|---|---|---|---|---|---|---|---|---|---|---|---|---|---|---|---|---|
| | | C | Si | Mn | P | S | Ni | Cr | Mo | Cu | Nb | Ti | Al | N | B | |
| Comparison steel | 1 | 0.069 | 0.51 | 0.34 | 0.032 | 0.005 | 0.14 | 16.13 | 0.11 | 0.04 | - | 0.004 | - | 0.0160 | - | α |
| | 2 | 0.008 | 0.35 | 0.10 | 0.027 | 0.001 | 0.09 | 16.24 | 0.02 | - | - | 0.180 | 0.046 | 0.0120 | - | |
| | 3 | 0.014 | 0.42 | 0.58 | 0.028 | 0.003 | 0.16 | 17.25 | 0.02 | 0.06 | 0.40 | - | 0.007 | 0.0090 | - | |
| Invention steel | 4 | 0.007 | 0.48 | 0.09 | 0.024 | 0.001 | 0.10 | 17.25 | 0.33 | 0.02 | - | 0.270 | 0.087 | 0.0140 | - | |
| | 5 | 0.009 | 0.10 | 0.14 | 0.026 | 0.001 | 0.11 | 17.55 | 0.50 | 0.02 | 0.39 | - | 0.054 | 0.0120 | - | |
| | 6 | 0.003 | 0.09 | 0.09 | 0.032 | 0.001 | 0.10 | 17.52 | 0.87 | - | - | 0.180 | 0.071 | 0.0130 | - | |
| | 7 | 0.006 | 0.27 | 0.09 | 0.021 | 0.001 | 0.12 | 18.15 | 1.85 | 0.04 | 0.32 | 0.025 | 0.036 | 0.0076 | - | |
| | 8 | 0.006 | 0.20 | 0.13 | 0.030 | 0.001 | 0.11 | 22.14 | 1.12 | 0.02 | 0.20 | 0.204 | 0.074 | 0.0115 | - | |
| | 9 | 0.004 | 0.07 | 0.24 | 0.028 | 0.001 | 0.22 | 29.32 | 1.88 | 0.05 | 0.18 | 0.190 | 0.110 | 0.0150 | - | |
| | 10 | 0.003 | 0.08 | 0.09 | 0.030 | 0.001 | 0.10 | 17.00 | 0.85 | - | - | 0.175 | 0.073 | 0.0125 | 0.0005 | |
| | 11 | 0.005 | 0.28 | 0.10 | 0.020 | 0.001 | 0.12 | 18.02 | 1.85 | 0.03 | 0.30 | - | 0.025 | 0.0075 | - | |
| | 31 | 0.007 | 0.47 | 0.09 | 0.025 | 0.001 | 0.10 | 16.35 | 0.35 | 0.02 | - | 0.250 | 0.080 | 0.0155 | - | |
| | 41 | 0.005 | 0.25 | 0.10 | 0.022 | 0.001 | 0.10 | 18.47 | 2.25 | - | - | - | - | 0.0082 | - | |
| Comparison steel | 21 | 0.070 | 0.54 | 0.79 | 0.035 | 0.006 | 8.04 | 18.12 | 0.20 | 0.31 | - | - | - | 0.0260 | 0.0005 | 7 |
| | 22 | 0.062 | 0.56 | 1.52 | 0.025 | 0.001 | 19.08 | 24.50 | 0.24 | 0.13 | 0.03 | - | 0.006 | 0.0290 | 0.0026 | |
| Invention steel | 23 | 0.017 | 0.53 | 1.74 | 0.027 | 0.002 | 12.58 | 17.22 | 2.73 | 0.34 | - | - | - | 0.0070 | 0.0022 | |
| | 51 | 0.043 | 2.77 | 0.35 | 0.025 | 0.001 | 11.84 | 17.62 | 0.51 | 1.81 | - | - | - | 0.0180 | 0.0021 | |

**EP 2 337 144 B1**

To evaluate corrosion resistance of stainless steel plate itself on which a catalyst layer such as platinum is not formed, a test piece of 35 × 35 mm was cut out of each material under test, and the surface (including ends) was finished by polishing with #600 dry emery, thereby obtaining a corrosion resistance test piece.

As a test liquid simulating an electrolyte solution of a dye-sensitized solar cell, a solution obtained by dissolving 0. 05 mol/liter of iodine $I_2$ and 0. 5 mol/liter of lithium iodide LiI in an acetonitrile solvent was prepared.

10 ml of the test liquid was placed in a Teflon (registered trade mark)-made container, and the corrosion resistance test piece was dipped in the liquid. The container was covered with a lid to suppress volatilization of a solvent. The container was held in a thermostatic bath of 80°C, and after passing 500 hours from the initiation of dipping, the test piece was taken out of the container. Each steel grade was tested with the sample number n=3.

Weight change (weight of test piece after dipping - initial weight of test piece) was measured on each test piece after dipping for 500 hours. Of the weight change values of n=3, the lowest value (that is, the largest weight loss) was employed as the result of weight change of its steel grade. In the case that the weight change value is minus, it means that corrosion loss occurs. The test piece of which the weight change in the dipping test for 500 hours is not a value at a minus side of -1 $g/m^2$ corresponds to the grade that "corrosion loss is 1 $g/m^2$ or less", and it is judged to be acceptable. Furthermore, the surface of the test piece after the dipping test for 500 hours was visually observed, and the appearance was examined. In this case, of n=3, the appearance of the test piece that the degree of corrosion is most remarkable was employed as the result of its steel grade.

For the reference, excluding the steel grade in which the entire surface corrosion or the end corrosion was observed in the appearance after dipping for 500 hours, the test pieces after the observation were again subjected to the above dipping test, and the weight change and the appearance in the dipping test for 1,000 hours in total were examined.

The results are shown in Table 2.

TABLE 2

| Classification | Sample No. | Steel No. | Plate thickness (mm) | After dipping test for 500 hours | | After dipping test for 1,000 hours | |
|---|---|---|---|---|---|---|---|
| | | | | Weight change ($g/m^2$) | Appearance | Weight change ($g/m^2$) | Appearance |
| Comparison steel | 1 | 1 | 0.53 | -137.771 | Entire surface corrosion | - | - |
| | 2 | 2 | 0.50 | -54.718 | Dot rust, intermediate | -56.155 | Dot rust, lots ; surface corrosion |
| | 3 | 3 | 0.50 | -49.641 | Dot rust, large | -51.714 | Dot rust, lots large; surface corrosion |
| Invention steel | 4 | 4 | 0.81 | -0.637 | Dot rust, small | -1.004 | Dot rust, small |
| | 5 | 5 | 0.48 | 0.000 | Dot rust, small | -0.114 | Dot rust, small |
| | 6 | 6 | 0.40 | 0.008 | Normal | 0.073 | Normal |
| | 7 | 7 | 0.28 | 0.008 | Normal | -0.033 | Normal |
| | 8 | 8 | 0.40 | 0.000 | Normal | 0.008 | Normal |
| | 9 | 9 | 0.37 | 0.024 | Normal | 0.008 | Normal |
| | 10 | 10 | 0.40 | 0.005 | Normal | 0.070 | Normal |
| | 11 | 11 | 0.28 | 0.008 | Normal | -0.025 | Normal |
| | 31 | 31 | 0.50 | -0.845 | Normal | -1.435 | Dot rust, small |
| | 41 | 41 | 0.28 | 0.003 | Normal | 0.002 | Normal |

(continued)

| Classification | Sample No. | Steel No. | Plate thickness (mm) | After dipping test for 500 hours | | After dipping test for 1,000 hours | |
|---|---|---|---|---|---|---|---|
| | | | | Weight change (g/m$^2$) | Appearance | Weight change (g/m$^2$) | Appearance |
| Comparison steel | 21 | 21 | 0.53 | -127.649 | Entire surface corrosion | - | - |
| | 22 | 22 | 0.50 | -1.282 | End corrosion | - | - |
| Invention steel | 23 | 23 | 0.50 | 0.024 | Normal | 0.016 | Normal |
| | 51 | 51 | 0.53 | -0.167 | Dot rust, small | -0.545 | Dot rust, small |

As is seen from Table 1 and Table 2, it was conformed that the invention steels containing 16% or more of Cr and 0.3% or more of Mo show the corrosion loss of 1 g/m$^2$ or less in the case of dipping in an iodide ion-containing electrolyte under severe conditions of 80°C for 500 hours in a bare state, less occurrence of dot rust, and excellent corrosion resistance.

Roughened Surface of Stainless Steel Substrate

As a result of intensive investigations, the present inventors have found that in a dye-sensitized solar cell using a stainless steel plate having many pit-shaped concave portions of specific form, formed on the surface thereof, for a substrate of a counter electrode, photoelectric conversion efficiency is high as compared with the case of using a stainless steel plate having a smooth surface. Regarding the conversion efficiency, the present inventors have found that rather than the amount of a catalyst supported, an opening size of the concave portion and an area ratio of the concave portion (that is, roughening form) affect the conversion efficiency. As a result of detailed investigations, it has been found that use of the stainless steel plate having pit-shaped concave portions having an average opening size of 0.5 $\mu$m or less, for example, from 0.3 to 5 $\mu$m, in a proportion of an area ratio of 10% or more on the surface, and having a catalyst thin film layer on the surface thereof, is more effective to improve the photoelectric conversion efficiency.

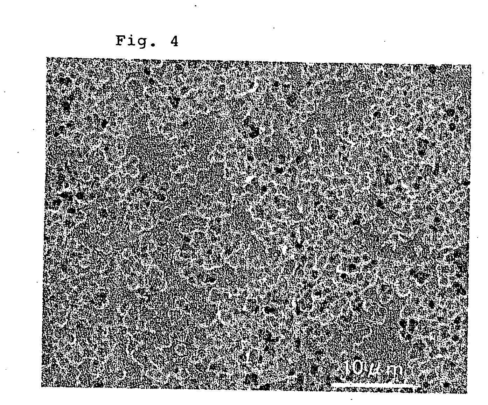

An SEM photograph of the surface of a stainless steel plate having pit-shaped concave portions is shown in Fig. 4. The individual pit-shaped portion is constituted of a pit having a circular opening portion. The term "circular" means a shape in which in the case of seeing the surface of a steel plate in a parallel direction to a plate thickness direction, when a diameter of the longest portion in a contour of the opening portion is called a "long diameter" and a diameter of the longest portion in right angle direction to the long diameter is called a "short diameter", an aspect ratio represented by long diameter/short diameter is 2 or less. Depending on the contour of the pit opening portion, the pit in which the whole image of the shape of the opening portion is clearly seen is observed. However, in the portion in which a plurality of pits is connected with each other to form the concave portion, the pit in which the whole image is not developed in the contour is present. Even in such pits, there are many pits that can estimate the whole image (that is, the shape of a circular opening portion) from the contour with relatively good precision.

The average opening size D can be determined as follows. That is, a straight line is drawn on an image seeing the surface of a steel plate in a parallel direction to a plate thickness direction, pits in which the whole image of the shape of the opening portion appears in the contour, or pits in which the whole image of the shape of the opening portion can be estimated from the contour, are randomly selected 30 in total from the pits whose contour crossing the straight line. The greatest size of each pit in a parallel direction to the straight line is measured, and a value obtained by the arithmetic average of those values is used as an average opening size D. A total of 30 pits may be selected by drawing a plurality of straight lines. A method for "randomly selecting a total of 30 pits" can employ, for example, a method of picking up a total of 100 pits by a method of picking up all of pits in which the whole image of the shape of the opening portion appears along the straight line and pits capable of estimating the whole image of the shape of the opening portion, and randomly selecting 30 pits from those.

Regarding the mechanism that the photoelectric conversion efficiency is improved by using a counter electrode comprising a stainless steel plate having pit-shaped concave portions having an average opening size D of 0.5 $\mu$m or less, for example, from 0.3 to 5 $\mu$m, on the surface thereof in a proportion of an surface ratio of 10% or more, and a catalyst thin film layer formed on the surface of the stainless steel plate, there are many portions not yet clarified. However, the following is considered. On the catalyst thin film layer of the counter electrode, reduction reaction occurs in which ion (for example, $I_3^-$) in the electrolyte receives an electron, thereby returning to iodide ion ($I^-$). It is considered that the catalyst layer formed on the surface of the stainless steel plate having pit-shaped concaved portions increases its surface area by the underlying concavity and convexity and additionally has unique surface form reflecting the underlying pit shape, and as a result, the effect of increasing "reduction reaction active spot" is large. It is estimated that this is a factor to bring further improvement of the photoelectric conversion efficiency. As a result of various investigations, it is effective to use a stainless steel plate having pit-shaped concave portions having an average opening size D of 0.5 $\mu$m or less, for example, from 0.3 to 5 $\mu$m, formed thereon. In the case that the average opening size in the concave portions exceeds 5 $\mu$m and in the case that the area ratio of the concave portions is lower than 10%, the effect of improving photoelectric conversion efficiency is reduced.

As the surface of the substrate having the pit-shaped concave portions, it is preferred that the surface roughness SRa is in a range of from 0.1 to 1.5 $\mu$m. When SRa is 0.1 $\mu$m or more, the effect of increasing surface area can further effectively be obtained. SRa is more preferably 0.3 $\mu$m or more. However, it is not easy to obtain a roughened surface having SRa of 1.5 $\mu$m or more by electrolytic roughening.

The unique roughening form can generally be obtained by, for example, applying an alternating electrolysis treatment in a ferric chloride solution to a stainless steel plate having an unroughened surface property, such as general annealing/acid pickling finish, BA annealing finish or skin pass rolling finish.

Catalyst Thin Film Layer

A catalyst thin film layer is formed on the surface of the counter electrode applied in the present invention, and platinum is used in the catalyst thin film layer. In the case of using platinum, sputter coating is employed as the coating method. However, even a thin catalyst layer can sufficiently improve the conversion efficiency. According to the investigations by the present inventors, even in the case of forming an extremely thin platinum film having an average film thickness of about 1 nm, it was confirmed to function as a cell. The average film thickness of the catalyst layer is, for example, from about 1 to 300 nm. To achieve both stability of conversion efficiency and economic efficiency, it is more effective to control the film thickness to a range of from 10 to 200 nm, or from 20 to 100 nm. Such a thin catalyst layer is referred to as a "catalyst thin film layer" in the present specification. However, it is general that a passive film having poor conductivity is formed on the surface of stainless steel. Therefore, it is more effective to form the catalyst thin film layer after removing the passive film. In the case of using a sputter coating method, it is desired that the passive film is removed by reverse-sputtering the surface of a stainless steel substrate in a sputtering apparatus, and the catalyst material is then sputter-coated.

Photoelectrode and Electrolyte

The semiconductor layer constituting the photoelectrode is not limited so long as it is an oxide semiconductor particle layer constituting a light pole of a general dye-sensitized solar cell. For example, a porous thin film comprising at least one oxide semiconductor particle of titanium dioxide ($TiO_2$), tin oxide ($SnO_2$), tungsten oxide ($WO_3$), zinc oxide ($ZnO_2$) and niobium oxide ($Nb_2O_5$) as an ingredient can be employed. The semiconductor layer is preferably a layer exhibiting a so-called light confinement effect by increasing the proportion of particles having a large particle size in the oxide semiconductor particles in the surface layer portion rather than the vicinity of the surface of a light-transmitting and conductive material. The sensitizing dye supported on the semiconductor layer can use ruthenium complex, porphyrin, phthalocyanine, coumarin, indoline, eosin, rhodamine, merocyanine and the like. The electrolyte can use an electrolyte for a general dye-sensitized solar cell, containing iodine ($I_2$) and iodide ion.

EXAMPLES

Example 1

Test examples examining the effect of improving conversion efficiency by a surface-roughened stainless steel plate are shown below.

Stainless steel having a composition shown in Table 3 was melted, and 0.2 mm thick cold-rolled annealed steel plate (No. 2D finish) was produced by a general stainless steel plate production step.

TABLE 3

| Classification | Steel | Chemical composition (% by mass) | | | | | | | | | | |
|---|---|---|---|---|---|---|---|---|---|---|---|---|
| | | C | Si | Mn | Ni | Cr | Mo | Cu | Nb | Ti | Al | N |
| Invention steel | A | 0.003 | 0.09 | 0.09 | 0.10 | 17.52 | 0.87 | - | - | 0.18 | 0.071 | 0.013 |
| | B | 0.006 | 0.20 | 0.13 | 0.11 | 22.14 | 1.12 | 0.20 | 0.20 | 0.20 | 0.074 | 0.012 |
| | C | 0.003 | 0.10 | 0.12 | - | 22.05 | 1.25 | - | - | - | - | 0.011 |

Test piece cut out of the above steel plate was dipped in a ferric chloride aqueous solution having $Fe^{3+}$ concentration of 30 g/liter at 50°C. Anode electrolysis current density was set to 3 $kA/m^2$, cathode electrolysis current density was set to 0.3 $kA/m^2$, and a surface roughening treatment was carried out at various alternating cycles and electrolysis times. The surface having been subjected to surface roughening was observed with a scanning electron microscope (SEM), and an average opening size D of pit-shaped concave portions and an area ratio of pit-shaped concave portions were measured with the method described before. On the roughened surface, a three-dimensional surface profile of a rectangular region of 50 $\mu$m $\times$ 50 $\mu$m was measured using a scanning laser microscope (OLS1200, manufactured by Olympus Corporation). The three-dimensional surface roughness SRa calculated from the data of the profile was obtained. Each treatment condition and roughening form are shown in Table 4.

The materials under test (surface-roughened stainless steel plate substrate and stainless steel plate substrate without electrolysis roughening treatment) were set in a sputtering apparatus, and the surface was cleaned with reverse sputtering and then subjected to main sputtering using a platinum target for 10 minutes. Thus, a counter electrode having a platinum catalyst thin film layer formed thereon was prepared. In this case, an average film thickness of the platinum film is about 40 nm. Counter electrodes obtained by forming ITO (Indium-doped tin oxide) film on a glass substrate (hereinafter referred to as "Nesa glass") and then subjecting the Nesa glass to main sputtering for 10 minutes and 90 minutes were prepared as comparison counter electrodes. By the sputtering for 90 minutes, the average film thickness of the platinum film is about 360 nm. Using those counter electrodes, small-sized cells were prepared, and conversion efficiency was measured. The experiment was conducted by the following procedures.

As a light-transmitting and conductive material for a photoelectrode, a PEN film substrate having ITO film formed thereon (PECF-IP, manufactured by Peccell Technologies, Inc.) was prepared. As a material for obtaining a semiconductor layer, $TiO_2$ paste (PECC-01-06, manufactured by Peccell Technologies, Inc.) was prepared. The $TiO_2$ paste was applied to the ITO surface of the PEN film substrate by a doctor blade method and allowed to stand at room temperature to dry. The thickness of the semiconductor layer obtained was 10 $\mu$m. Using a ruthenium complex dye (PECD-07, manufactured by the same company) as a sensitizing dye, a dye solution having the sensitizing dye dispersed in an acetonitrile/tert-butanol mixed solvent was obtained. The film substrate having the semiconductor layer formed thereon was dipped in the dye solution for 3.5 hours, thereby obtaining a photoelectrode in which the sensitizing dye is supported on the semiconductor layer.

The photoelectrode and the counter electrode were combined through an insulating spacer so as to surround an electric generation portion, and a cell structure having a distance between ITO surface of the photoelectrode and the counter electrode of 50 $\mu$m was produced. An electrolyte (PECE-K01, manufactured by Peccell Technologies, Inc.) was injected in the cell structure using a microcylinder, thereby obtaining a dye-sensitized solar cell.

I-V characteristic of each dye-sensitized solar cell was measured with Model 2400 Source Meter, manufactured by KEITHLEY Instruments, while irradiating the dye-sensitized solar cell with pseudo sunlight of AM 1.5 and 100 $mW/cm^2$ using SOLAR SIMULATOR, manufactured by Yamashita Denso Corporation, and values of short-circuit current $J_{sc}$, open voltage $V_{oc}$ and form factor FF were obtained. The value of photoelectric conversion efficiency $\eta$ was obtained from those values by the following formula (1).

$$\text{Photoelectric conversion efficiency } \eta \ (\%)$$

$$= \text{Short-circuit current } J_{sc} \ (mA/cm^2) \times \text{Open voltage } V_{oc} \ (V) \times$$

$$\{\text{Form factor FF/Incident light 100 } (mW/cm^2)\} \times 100 \qquad (1)$$

Photoelectric conversion efficiency $\eta_0$ in a dye-sensitized solar cell (No. 62) using a counter electrode obtained by sputter-coating Nesa glass with platinum for 90 minutes is used as the standard, the value of a ratio ($\eta/\eta_0 \times 100$) of the photoelectric conversion efficiency $\eta$ of each dye-sensitized solar cell to $\eta_0$ is expressed as "efficiency ratio to the standard", and cell performance was evaluated.

The results are shown in Table 4.

TABLE 4

| Classification | No. | Steel | Electrolysis condition | | Surface-roughing form | | | Platinum sputtering time (min) | Efficiency ratio to the standard (%) |
|---|---|---|---|---|---|---|---|---|---|
| | | | Cycle (Hz) | Electrolysis time (sec) | Average opening size D ($\mu$m) | Area ratio of concave portion (%) | Surface roughness ($\mu$m) | | |
| Invention Example | 51 | A | 1 | 60 | 4.7 | 89 | 0.62 | 10 | 108 |
| | 52 | A | 5 | 60 | 3.5 | 91 | 0.58 | 10 | 108 |
| | 53 | B | 10 | 60 | 2.4 | 87 | 0.43 | 10 | 106 |
| | 54 | C | 15 | 80 | 1.3 | 95 | 0.38 | 10 | 112 |
| | 55 | B | 5 | 120 | 3.2 | 100 | 0.55 | 10 | 110 |
| | 56 | B | 10 | 30 | 1.2 | 13 | 0.12 | 10 | 108 |
| | 57 | C | 5 | 5 | 3.7 | 8 | 0.23 | 10 | 100 |
| | 58 | B | 0.5 | 60 | 8.1 | 90 | 1.22 | 10 | 101 |
| | 59 | A | 22 | 60 | 0.3 | 15 | 0.08 | 10 | 101 |
| | 60 | B | No electrolysis roughening treatment | | | | | 10 | 100 |
| Comparative Example | 61 | Nesa glass | | | | | | 10 | 90 |
| | 62 | Nesa glass | | | | | | 90 | 100 (standard) |

As is seen from Table 4, the invention cells showed high value of "efficiency ratio to the standard" as compared with Nesa glass having platinum sputtering time of 10 minutes. Furthermore, despite that the platinum sputtering time is short as 10 minutes, the invention cells showed a value equivalent to or higher than the value of Nesa glass having the sputtering time of 90 minutes. The amount of platinum used can be reduced by using the stainless steel plate defined in the present invention in a substrate of a counter electrode. In particular, by using a surface-roughened stainless steel plate having pit-shaped concave portions having an average opening size D of 5 $\mu$m or less in a proportion of an area ratio of 10% or more and having a surface roughness SRa of from 0.1 to 1.5 $\mu$m as a substrate, the "efficiency ratio to the standard" was greatly improved as compared with the case (No. 60) without electrolysis. The reason for this is considered due to that reduction reaction active spots in the counter electrode are increased by the increase in the surface area of the counter electrode due to the pit-shaped concave portions present on the surface of the stainless steel.

Example 2

As a light-transmitting and conductive material for a photoelectrode, a glass substrate having FTO (fluorine-doped tin oxide) film formed thereon (hereinafter referred to as "FTO glass") was prepared. As a material for obtaining a semiconductor layer, three kinds of TiO$_2$ pastes for photoelectric conversion layer formation, in which compounding ratios between TiO$_2$ particles having an average particle diameter of 20 nm and TiO$_2$ particles having an average particle diameter of 100 nm are 10:0, 8:2 and 6:4, as mass ratio, were prepared. Three layers of the paste having the compounding ratio of 10:0, two layers of the paste having the compounding ratio of 8:2 and one layer of the paste having the compounding ratio of 6:4 were laminated on the surface of the FTO film of the FTO glass in this order. Thus, a burned film of a porous functional semiconductor layer having high light confinement effect was formed. In this case, the film thickness was increased by repeating the step of "application of paste → burning" every layer. Application of the paste was conducted using a screen printer. To decrease surface unevenness of the coating film, the coating film was allowed to stand for 2 hours at room temperature after the application, and then burned in an electric furnace under the condition of temperature increase to 520°C over 1 hour → holding at 520°C for 1 hour. The thickness of the semiconductor layer finally obtained was 34 $\mu$m.

A dye solution was obtained by using tris(isothiocyanato)-(2,2';6',2"-terpiridyl-4,4',4"-tricarboxylic acid)-ruthenium (II) tris-tetrabutyl ammonium as a sensitizing dye, dissolving the sensitizing dye in ethanol in a concentration of 0.2 mM, and further dissolving deoxycholic acid as a coadsorbate therein in a concentration of 20 mM. The glass substrate having above semiconductor layer formed thereon (photoelectrode structure) was dipped in the dye solution for 24 hours, thereby obtaining a photoelectrode in which the sensitizing dye is supported on the semiconductor layer.

As electrolytes, a solution obtained by dissolving 0.05 M of iodine, 0.1 M of lithium iodide, 0.6 M of 1,2-dimethyl-3-propylimidazolium iodide and 0.5 M of t-butylpyridine in an acetonitrile solvent was prepared. The preparation of the solution was conducted in a nitrogen atmosphere.

As a substrate for a counter electrode, a stainless steel plate of Steel B in Table 3 (No. 2D finish material) was prepared. A stainless steel plate obtained by roughening the 2D finish surface with an alternating electrolysis treatment in a ferric chloride aqueous solution (No. 107) was prepared. As to the roughened surface was that pit-shaped concave portions having an average opening size D of 2.4 $\mu$m are formed in an area ratio of 50%, and the surface roughness SRa is 0.30 $\mu$m.

Both stainless steel plates were set in a sputtering apparatus, and reverse sputtering was conducted at an output of 20 W for 10 minutes to remove a passive coating film on the surface. Main sputtering was then conducted at an output of 60 W using a platinum target, thereby forming a platinum catalyst thin film layer on the surface of the substrate of the stainless steel in both plates. By changing the sputtering time in a range between 60 seconds and 10 minutes, various counter electrodes having different thickness of the catalyst thin film layer were prepared. This embodiment corresponds to the case that the average thickness of the catalyst thin film layer is varied in a range from about 10 nm to about 100 nm.

Counter electrodes obtained by subjecting FTO glass to main sputtering for a time between 60 seconds and 120 minutes were prepared as comparison counter electrodes. In this case, by the sputtering for 120 minutes, the average film thickness of a platinum film is about 1 $\mu$m.

The photoelectrode and the counter electrode were combined through an insulating spacer so as to surround an electric generation portion, and a cell structure having a distance between FTO surface of the photoelectrode and the counter electrode of 50 $\mu$m was produced. The electrolyte was injected in the cell structure using a microcylinder, thereby obtaining a dye-sensitized solar cell.

I-V characteristic of each dye-sensitized solar cell when irradiating each dye-sensitized solar cell with pseudo sunlight was measured in the same method as in Example 1, and values of short-circuit current $J_{sc}$, open voltage $V_{oc}$ and form factor FF were obtained. The value of photoelectric conversion efficiency $\eta$ was obtained from those values by the formula (1) above.

Here, photoelectric conversion efficiency $\eta_0$ in a dye-sensitized solar cell (No. 208) using a counter electrode obtained by sputter-coating FTO glass with platinum for 120 minutes was used as the standard, and the value of a ratio ($\eta/\eta_0 \times 100$) of the photoelectric conversion efficiency $\eta$ of each dye-sensitized solar cell to $\eta_0$ was expressed as "efficiency ratio to the standard".

The results are shown in Table 5.

TABLE 5

| Classification | Test No. | Substrate of counter electrode | Platinum sputtering time | $J_{SC}$ (mA/cm$^2$) | $V_{OC}$ (V) | FF | $\eta$ (%) | Efficiency ratio to the standard (%) |
|---|---|---|---|---|---|---|---|---|
| Invention Example | 101 | No.2D Finish SUS | 60 sec | 21.8 | 0.69 | 0.64 | 9.6 | 97 |
| | 102 | No.2D Finish SUS | | 20.7 | 0.69 | 0.70 | 10.0 | 101 |
| | 103 | No.2D Finish SUS | 3 min | 21.1 | 0.71 | 0.66 | 9.9 | 100 |
| | 104 | No.2D Finish SUS | | 20.1 | 0.71 | 0.69 | 9.8 | 100 |
| | 105 | No.2D Finish SUS | 10 min | 20.7 | 0.70 | 0.68 | 9.9 | 100 |
| | 106 | No.2D Finish SUS | | 20.8 | 0.70 | 0.68 | 9.9 | 100 |
| | 301 | Rough-surfaced SUS | 60 sec | 21.6 | 0.68 | 0.69 | 10.1 | 102 |
| | 302 | Rough-surfaced SUS | | 21.7 | 0.69 | 0.69 | 10.3 | 104 |
| | 303 | Rough-surfaced SUS | 3 min | 21.7 | 0.68 | 0.70 | 10.3 | 104 |
| | 304 | Rough-surfaced SUS | | 21.8 | 0.68 | 0.69 | 10.2 | 103 |
| | 107 | Rough-surfaced SUS | 10 min | 21.8 | 0.67 | 0.70 | 10.2 | 103 |
| | 305 | Rough-surfaced SUS | | 21.7 | 0.68 | 0.70 | 10.3 | 104 |
| Comparative Example | 201 | FTO glass | 60 sec | 18.7 | 0.69 | 0.71 | 9.2 | 93 |
| | 202 | FTO glass | | 18.6 | 0.68 | 0.71 | 9.0 | 91 |
| | 203 | FTO glass | 3 min | 19.3 | 0.67 | 0.72 | 9.3 | 94 |
| | 204 | FTO glass | | 18.9 | 0.68 | 0.72 | 9.3 | 94 |
| | 205 | FTO glass | 10 min | 19.3 | 0.68 | 0.72 | 9.4 | 95 |
| | 206 | FTO glass | | 19.3 | 0.69 | 0.72 | 9.6 | 97 |
| | 207 | FTO glass | 120 min | 20.2 | 0.69 | 0.71 | 9.9 | 100 |
| | 208 | FTO glass | | 20.2 | 0.69 | 0.71 | 9.9 | 100 (Standard) |

As is seen from Table 5, regarding the cells of the invention examples using a stainless steel plate as a substrate of a counter electrode, the photoelectric conversion efficiency $\eta$ approaches the saturation at the time that the platinum sputtering time is 60 seconds, and almost stably reaches the saturation at the time of 3 minutes. By the thin catalyst supporting, high photoelectric conversion efficiency nearly comparable to that of cells (Nos. 207 and 208) of the type in which the best performance has conventionally been obtained is obtained. On the other hand, regarding the cells of the comparative examples using FTO glass as a substrate of a counter electrode, the photoelectric conversion efficiency $\eta$

does not reach the saturation even at the time that the platinum sputtering time is 10 minutes. To sufficiently exhibit cell performance, it is necessary that the sputtering time is about 120 minutes, and a catalyst layer having larger thickness is provided. From those results, it was confirmed that in the dye-sensitized solar cell of the present invention using a stainless steel plate in a substrate of a counter electrode, the amount of expensive platinum used can greatly be reduced. By using a stainless steel plate having a roughened surface for a substrate, the "efficiency ratio to the standard" was improved in comparison to the case without roughening treatment.

Brief Description of the Drawings

Fig. 1 is a view schematically showing the constitution of a general dye-sensitized solar cell.
Fig. 2 is a view schematically showing the constitution of the dye-sensitized solar cell of the present invention.
Fig. 3 is a view schematically showing the constitution of a type of the dye-sensitized solar cell of the present invention, which uses a surface-roughened stainless steel plate for a counter electrode.
Fig. 4 is an SEM photograph of the surface of a stainless steel plate having pit-shaped concave portions.

Description of Reference Numerals and Signs

| 1 | Solar cell |
|---|---|
| 2 | Light-transmitting substrate |
| 3 | Light-transmitting and conductive material |
| 4 | Substrate |
| 5 | Conductive material |
| 6 | Semiconductor layer |
| 7 | Semiconductor particle |
| 8 | Sensitizing dye |
| 9 | Electrolyte |
| 10 | Catalyst layer |
| 11 | Catalyst thin film layer |
| 20 | Incident light |
| 21 | Stainless steel substrate |
| 30 | Photoelectrode |
| 40 | Counter electrode |
| 50 | Load |

Claims

1. A dye-sensitized solar cell comprising a photoelectrode comprising a light-transmitting and conductive material and a semiconductor layer having a sensitizing dye supported thereon, formed on the surface of the light-transmitting and conductive material, an electrolyte and a counter electrode, wherein the counter electrode is constituted of a material comprising a substrate comprising ferrite stainless steel having pit-shaped concave portions having an average opening size D of 5 $\mu$m or less in a proportion of an area ratio of 10% or more on the surface thereof, and having a composition of, in % by mass, C: 0.15% or less, Si: 1.2% or less, Mn: 1.2% or less, P: 0.04% or less, S: 0.03% or less, Ni: 0.6% or less, Cr: 16 to 32%, Mo: 0.3 to 3%, Cu: 0 to 1%, Nb: 0 to 1%, Ti: 0 to 1%, Al: 0 to 0.2%, N: 0.025% or less, B: 0 to 0.01%, and the remainder being Fe and unavoidable impurities, and a sputter coated platinum catalyst thin film layer formed on the substrate, and the semiconductor layer of the photoelectrode and the catalyst thin film layer of the counter electrode face through the electrolyte.

2. The dye-sensitized solar cell according to claim 1, wherein the ferrite stainless steel has a Cr content of from 17 to 32% and a Mo content of from 0.8 to 3%.

3. The dye-sensitized solar cell according to claim 1, wherein the surface having the pit-shaped concave portion of the stainless steel plate has surface roughness SRa of from 0.1 to 1.5 $\mu$m.

**4.** The dye-sensitized solar cell according to claim 1, wherein the sputtered platinum catalyst thin film layer is directly bonded to the substrate without a passive film therebetween.

**Patentansprüche**

**1.** Farbstoff-Solarzelle, welche eine Photoelektrode aufweist, die ein lichtdurchlässiges und leitendes Material und eine Halbleiterschicht mit einem darauf aufgebrachtem lichtempfindlichen Farbstoff aufweist, die an der Oberfläche des lichtdurchlässigen und leitenden Materials geformt ist, weiter ein Elektrolyt und eine Gegenelektrode, wobei die Gegenelektrode aus einem Material gebildet ist, welches ein Substrat aufweist, das rostfreien Ferritstahl mit grübchenförmigen konkaven Teilen aufweist, die eine durchschnittliche Öffnungsgröße D von 5 $\mu$m oder weniger in einem Anteil eines Flächenverhältnisses von 10 % oder mehr an der Oberfläche davon haben, und welches eine Zusammensetzung in Massen-% von 0,15 % oder weniger C, 1,2 % oder weniger Si, 1,2 % oder weniger Mn, 0,04 % oder weniger P, 0,03 % oder weniger S, 0,6 % oder weniger Ni, 16 bis 32 % Cr, 0,3 bis 3 % Mo, 0 bis 1 % Cu, 0 bis 1 % Nb, 0 bis 1 % Ti, 0 bis 0,2 % Al, 0,025 % oder weniger N, 0 bis 0,01 % B hat, und wobei der Rest Fe und unvermeidbare Verunreinigungen ist, und eine durch Sputtern aufgebrachte Platinkatalysator-Dünnfilmschicht, die auf dem Substrat ausgebildet ist, und wobei die Halbleiterschicht der Photoelektrode und die Katalysator-Dünnfilmschicht der Gegenelektrode durch das Elektrolyt zueinander weisen.

**2.** Farbstoff-Solarzelle nach Anspruch 1, wobei der rostfreie Ferritstahl einen Cr-Gehalt von 17 bis 32 % und einen Mo-Gehalt von 0,8 bis 3 % hat.

**3.** Farbstoff-Solarzelle nach Anspruch 1, wobei die Oberfläche mit dem grübchenförmigen konkaven Teil der rostfreien Stahlplatte eine Oberflächenrauigkeit SRa von 0,1 bis 1,5 $\mu$m hat.

**4.** Farbstoff-Solarzelle nach Anspruch 1, wobei die durch Sputtern aufgebrachte Platinkatalysator-Dünnfilmschicht direkt auf das Substrat gebondet bzw. aufgebracht ist, und zwar ohne einen passiven Film dazwischen.

**Revendications**

**1.** Cellule solaire sensibilisée à un colorant comprenant une photoélectrode comprenant un matériau transmettant la lumière et conducteur et une couche semiconductrice qui porte un colorant sensibilisateur, formée sur la surface du matériau transmettant la lumière et conducteur, un électrolyte et une contre-électrode, dans laquelle la contre-électrode est constituée d'un matériau comprenant un substrat comprenant de l'acier inoxydable contenant de la ferrite ayant des parties concaves en forme de fosse ayant une taille d'ouverture moyenne D de 5 $\mu$m ou moins dans une proportion d'un rapport de surface de 10 % ou plus sur sa surface, et ayant une composition de, en % en masse, C : 0,15 % ou moins, Si : 1,2 % ou moins, Mn : 1,2 % ou moins, P : 0,04 % ou moins, S : 0,03 % ou moins, Ni : 0,6 % ou moins, Cr : 16 à 32 %, Mo : 0,3 à 3 %, Cu : 0 à 1 %, Nb : 0 à 1 %, Ti : 0 à 1 % , Al : 0 à 0,2 %, N : 0,025 % ou moins, B : 0 à 0,01 %, et le reste étant du Fe et des impuretés inévitables, et une couche de film mince de catalyseur de platine déposé par pulvérisation formée sur le substrat, et la couche semiconductrice de la photoélectrode et la couche de film mince de catalyseur de la contre-électrode se faisant face à travers l'électrolyte.

**2.** Cellule solaire sensibilisée à un colorant selon la revendication 1, dans laquelle l'acier inoxydable contenant de la ferrite a une teneur en Cr de 17 à 32 % et une teneur en Mo de 0,8 à 3 %.

**3.** Cellule solaire sensibilisée à un colorant selon la revendication 1, dans laquelle la surface ayant la partie concave en forme de fosse de la plaque d'acier inoxydable a une rugosité de surface SRa de 0,1 à 1,5 $\mu$m.

**4.** Cellule solaire sensibilisée à un colorant selon la revendication 1, dans laquelle la couche de film mince de catalyseur de platine pulvérisé est collée directement au substrat sans film passif entre eux.

Fig. 1

Fig. 2

Fig.3

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11273753 A
- JP 2004311197 A
- JP 2006147261 A
- JP 2007048659 A
- JP 2004165015 A
- JP 2005235644 A
- JP 2007200656 A
- JP 2008034110 A
- JP 2005285472 A

**Non-patent literature cited in the description**

- **MA T et al.** Properties of several types of novel counter electrodes for dye-sensitized solar cells. *J. Electroanal. Chem. and Interfac. Electrochem.,* 2004, vol. 574, 77-83
- *Sol. Ener. Mater. Solar Cells,* 2006, vol. 90, 2881-2893
- *J. Phys. Chem. C,* 2008, vol. 112, 4011-4017